(19) 

Europäisches
Patentamt

European
Patent Office

Office européen
des brevets

(11) **EP 4 756 456 A1**

(12) **EUROPEAN PATENT APPLICATION**
published in accordance with Art. 153(4) EPC

(43) Date of publication:
**10.06.2026 Bulletin 2026/24**

(21) Application number: 25742116.4

(22) Date of filing: **07.01.2025**

(51) International Patent Classification (IPC):
*G01R 31/392* (2019.01)   *G01R 31/382* (2019.01)
*G01R 31/396* (2019.01)   *H01M 10/052* (2010.01)

(52) Cooperative Patent Classification (CPC):
**G01R 31/382; G01R 31/392; G01R 31/396;**
**H01M 10/052**

(86) International application number:
**PCT/KR2025/000327**

(87) International publication number:
**WO 2025/155019 (24.07.2025 Gazette 2025/30)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority:  **15.01.2024  KR 20240006174**

(71) Applicant: **LG Energy Solution, Ltd.**
**Seoul 07335 (KR)**

(72) Inventors:
• **KIM, Ji-Yeon**
  **Daejeon 34122 (KR)**
• **KIM, Young-Deok**
  **Daejeon 34122 (KR)**
• **PARK, Jun-Cheol**
  **Daejeon 34122 (KR)**
• **CHOI, Soon-Hyung**
  **Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **APPARATUS AND METHOD FOR DIAGNOSING BATTERY**

(57)   The apparatus for diagnosing a battery according to an embodiment of the present disclosure includes a profile obtaining unit configured to obtain a battery profile representing a corresponding relationship between voltage and capacity of a battery; a profile adjusting unit configured to adjust a preset first reference profile and a preset second reference profile to correspond to the battery profile and generate a first profile according to the adjustment result; and a control unit configured to diagnose a state of the battery based on a first feature value for a first feature point included in the first profile.

FIG. 1

## Description

TECHNICAL FIELD

This application is based on and claims priority from Korean Patent Application No. 10-2024-0006174, filed on January 15, 2024, with the Korean Intellectual Property Office, the disclosure of which is incorporated herein in its entirety by reference.

The present disclosure relates to an apparatus and method for diagnosing a battery, and more particularly, to an apparatus and method for diagnosing a battery, which diagnoses a state of a battery.

BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Although much research is being conducted on these batteries in terms of high capacity and high density, improving lifespan and safety is also important. In order to improve battery safety, technology that accurately diagnoses the current state of the battery is required.

In particular, it is necessary to prevent the phenomenon of lithium deposition on the negative electrode surface (Li-plating). If lithium is deposited on the negative electrode surface, it causes side reactions with the electrolyte and changes in the kinetic balance of the battery, which may lead to battery deterioration. In addition, since lithium metal may be deposited on the negative electrode surface, an internal short circuit in the battery may occur, and there is a risk of ignition and explosion due to the internal short circuit. Therefore, it is necessary to develop a technology that may detect whether lithium metal is deposited on the negative electrode surface.

DISCLOSURE

Technical Problem

The present disclosure is designed to solve the problems of the related art, and therefore the present disclosure is directed to providing an apparatus and method for diagnosing a battery, which diagnoses a state of a battery in a non-destructive manner.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

An apparatus for diagnosing a battery according to one aspect of the present disclosure may comprise a profile obtaining unit configured to obtain a battery profile representing a corresponding relationship between voltage and capacity of a battery; a profile adjusting unit configured to adjust a preset first reference profile and a preset second reference profile to correspond to the battery profile and generate a first profile according to the adjustment result; and a control unit configured to diagnose a state of the battery based on a first feature value for a first feature point included in the first profile.

The control unit may be configured to diagnose the state of the battery as a normal state or an available lithium loss state.

The control unit may be configured to diagnose the state of the battery as the available lithium loss state when the first feature value exceeds a preset first criterion value.

The control unit may be configured to diagnose the state of the battery as the normal state when the first feature value is less than or equal to the first criterion value.

The control unit may be configured to calculate an available lithium loss rate based on a preset first reference value, a preset second reference value and the first feature value, compare the calculated available lithium loss rate with a preset second criterion value, and diagnose the state of the battery based on the comparison result.

The control unit may be configured to diagnose the state of the battery as the available lithium loss state when the available lithium loss rate exceeds the second criterion value.

The control unit may be configured to diagnose the state of the battery as the normal state when the available lithium loss rate is less than or equal to the second criterion value.

The first reference value may be preset to a SOC of a first reference point included in the first reference profile.

The second reference value may be preset to a SOC of a second reference point included in the first reference profile.

The first feature value may be a SOC of the first feature point included in the first profile.

A battery pack according to another aspect of the present disclosure may comprise the apparatus for diagnosing a battery according to one aspect of the present disclosure.

A vehicle according to still another aspect of the present disclosure may comprise the apparatus for diagnosing a battery according to one aspect of the present disclosure.

A method for diagnosing a battery according to still another aspect of the present disclosure may comprise a profile obtaining step of obtaining a battery profile representing a corresponding relationship between voltage and capacity of a battery; a profile adjusting step of adjusting a preset first reference profile and a preset second reference profile to correspond to the battery profile and generating a first profile according to the adjustment result; and a battery adjusting step of diagnosing a state of the battery based on a first feature value for a first feature point included in the first profile.

Advantageous Effects

According to an aspect of the present disclosure, since the degradation pattern of the battery may be specifically diagnosed, the current state of the battery may be qualitatively diagnosed in a non-destructive manner.

The effects of the present disclosure are not limited to the effects mentioned above, and other effects not mentioned will be clearly understood by those skilled in the art from the description of the claims.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a diagram schematically showing an apparatus for diagnosing a battery according to an embodiment of the present disclosure.

FIG. 2 is a drawing schematically showing an adjustment result of a first reference profile and a second reference profile according to an embodiment of the present disclosure.

FIG. 3 is a graph referenced to explain an example of each of the first reference profile and the second reference profile.

FIG. 4 is a graph referenced to explain an example of a battery profile of a target cell.

FIGS. 5 to 7 are drawings referenced to explain an example of a procedure for generating a comparison profile used for comparison with the battery profile according to an embodiment of the present disclosure.

FIGS. 8 to 10 are drawings referenced to explain another example of the procedure for generating a comparison profile used for comparison with the battery profile according to an embodiment of the present disclosure.

FIG. 11 is a drawing referenced to explain the difference between a first battery and a second battery.

FIG. 12 is a drawing illustrating an exemplary configuration of a battery pack including the apparatus for diagnosing a battery according to an embodiment of the present disclosure.

FIG. 13 is a drawing schematically showing a vehicle according to another embodiment of the present disclosure.

FIG. 14 is a diagram schematically showing a method for diagnosing a battery according to still another embodiment of the present disclosure.

BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

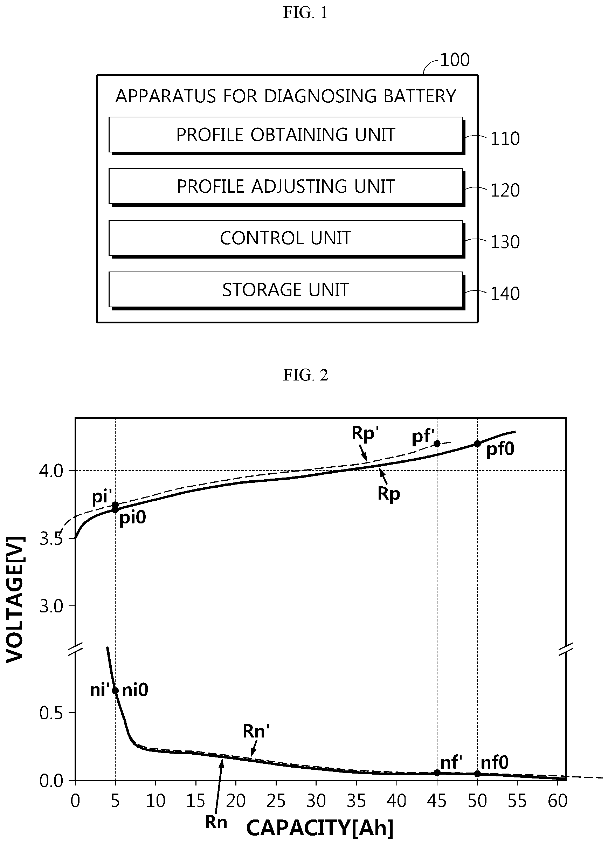

FIG. 1 is a diagram schematically illustrating an apparatus 100 for diagnosing a battery according to an embodiment of the present disclosure.

Referring to FIG. 1, the apparatus 100 for diagnosing a battery may include a profile obtaining unit 110, a profile adjusting unit 120, and a control unit 130.

The profile obtaining unit 110 may be configured to obtain a battery profile representing a corresponding relationship between voltage and capacity of the battery.

Here, the battery refers to an independent cell that has a negative terminal and a positive terminal and is physically separable. As an example, a lithium-ion battery or a lithium polymer battery may be considered as a battery. In addition, the type of batteries may be a cylindrical type, a prismatic type or a pouch type. Additionally, the battery may mean a battery bank, a battery module or a battery pack in which a plurality of cells are connected in series and/or parallel. Below, for convenience of explanation, the battery is explained as meaning one independent cell.

For example, the battery profile is a profile representing the corresponding relationship between voltage V and capacity Q when the SOC of the battery is charged from a preset charge start SOC, or 0%, to a preset charge end SOC, or 100%. As another example, the battery profile may represent the corresponding relationship between voltage V and capacity Q when the state of charge of the battery is discharged from the preset discharge start SOC, or 100%, to the preset discharge end SOC, or 0%.

For example, there is no special limitation on the C-rate in charging or discharging for generating the battery profile. However, preferably, the battery should be charged or discharged at a low rate in order to obtain a more accurate battery profile. For example, the battery profile may be generated in the process of charging or discharging the battery at 0.05 C.

For example, the profile obtaining unit 110 may directly receive the battery profile from the outside. That is, the profile obtaining unit 110 may obtain the battery profile by being connected to the outside via wire and/or wirelessly and receiving the battery profile.

As another example, the profile obtaining unit 110 may receive the battery information about the voltage and capacity of the battery. Then, the profile obtaining unit 110 may generate a battery profile based on the received battery information. That is, the profile obtaining unit 110 may obtain the battery profile by directly generating the battery profile based on the battery information.

The profile obtaining unit 110 may be connected to communicate with the profile adjusting unit 120. For example, the profile obtaining unit 110 may be connected to the profile adjusting unit 120 by wire and/or wirelessly. The profile obtaining unit may transmit the obtained battery profile to the profile adjusting unit 120.

The profile adjusting unit 120 may be configured to adjust the preset first reference profile Rp and the second reference profile Rn to correspond to the battery profile, and generate a first profile Rp' according to the adjustment result.

Here, the first reference profile Rp is a reference positive electrode profile, and may be a profile representing a corresponding relationship between the capacity and voltage of a preset reference positive electrode cell to correspond to the positive electrode of the battery. For example, the reference positive electrode cell may be a positive electrode coin half-cell or a positive electrode of a three-electrode cell. As a specific example, the first reference profile Rp may be preset to correspond to the positive electrode of the battery in the BOL (Beginning of Life) state. That is, the first reference profile Rp may be estimated as the positive electrode profile of the battery in the BOL state.

In addition, the second reference profile Rn is a reference negative electrode profile, and may be a profile representing a corresponding relationship between the capacity and voltage of a preset reference negative electrode cell to correspond to the negative electrode of the battery. For example, the reference negative electrode cell may be a negative electrode coin half-cell or a negative electrode of a 3-electrode cell. As a specific example, the second reference profile Rn may be preset to correspond to the negative electrode of the battery in the BOL state. That is, the second reference profile Rn may be estimated as the negative electrode profile of the battery in the BOL state.

Specifically, the profile adjusting unit 120 may adjust the first reference profile Rp and the second reference profile Rn to correspond to the battery profile. More specifically, the profile adjusting unit 120 may generate an adjusted first reference profile Rp and an adjusted second reference profile Rn by adjusting the first reference profile Rp and the second reference profile Rn. In addition, the profile adjusting unit 120 may generate a comparison profile from the adjusted first reference profile Rp and the adjusted second reference profile Rn. The profile adjusting unit 120 may adjust the first reference profile Rp and the second reference profile Rn until the comparison profile corresponds to the battery profile.

For example, the profile adjusting unit 120 may generate a plurality of comparison profiles by shifting or capacity-scaling the first reference profile Rp and the second reference profile Rn, and may specify a comparison profile having a minimum error with the battery profile among the plurality of comparison profiles. Then, the profile adjusting unit 120 may determine an adjusted first reference profile Rp and an adjusted second reference profile Rn corresponding to the specified comparison profile as the first profile Rp' and the second profile Rn', respectively. That is, the positive electrode profile representing the current state of the battery may be estimated as the first profile Rp', and the negative electrode profile may be estimated as the second profile Rn'.

FIG. 2 is a drawing schematically showing an adjustment result of a first reference profile Rp and a second reference profile Rn according to an embodiment of the present disclosure.

Specifically, in the embodiment of FIG. 2, the profile adjusting unit 120 may generate a first profile Rp' and a second profile Rn' by adjusting the first reference profile Rp and the second reference profile Rn. That is, the first profile Rp' and the second profile Rn' are generated according to the organic relationship between the first reference profile Rp and the second reference profile Rn.

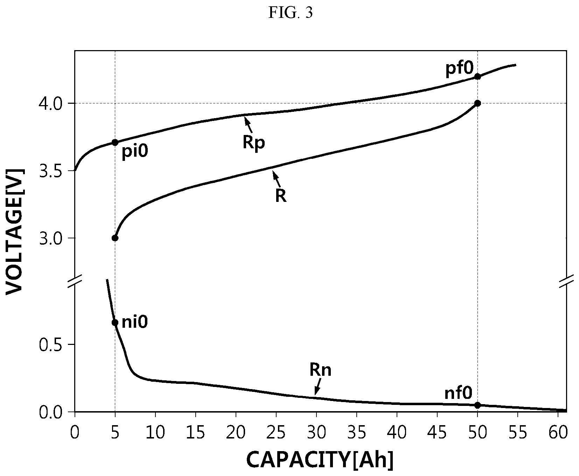

In relation to this, a more specific embodiment in which the profile adjusting unit 120 determines the first profile Rp' of the battery by adjusting the first reference profile Rp and the second reference profile Rn to correspond to the battery profile will be described later with reference to FIGS. 3 to 10.

The control unit 130 may be configured to diagnose the state of the battery based on the first feature value of the first feature point included in the first profile Rp'.

Specifically, the first profile Rp' includes a first feature point corresponding to a positive electrode participation start point (hereinafter referred to as pi) and a second feature point corresponding to a positive electrode participation end point (hereinafter referred to as pf). Here, the positive electrode participation start point means a positive electrode point where a reaction starts during a charging process or a positive electrode point where a reaction starts during a discharging process. The positive electrode participation end point means a positive electrode point where a reaction ends during a charging process or a positive electrode point where a reaction ends during a discharging process.

Similarly, the second profile Rn' includes a first feature point corresponding to a negative electrode participation start point (hereinafter referred to as ni) and a second feature point corresponding to a negative electrode participation end point (hereinafter referred to as nf). Here, the negative electrode participation start point means a negative electrode point where a reaction starts during the charging process or a negative electrode point where a reaction starts during the discharging process. The negative electrode participation end point means a negative electrode point where a reaction ends during the charging process or a negative electrode point where a reaction ends during the discharging process.

For example, in the embodiment of FIG. 2, the first profile Rp' may include a first feature point (pi') and a second feature point (pf'). The second profile Rn' may include a first feature point (ni') and a second feature point (nf').

The first feature value is a value representing at least one of capacity, voltage, or SOC (State of Charge) of the first feature point included in the first profile Rp'. Preferably, the first feature value is the SOC of the first feature point included in the first profile Rp'.

For example, the first feature value may be calculated as the SOC of the first feature point (pi') with respect to the capacity of the first profile Rp'. Assume that the entire capacity section of the first profile Rp' is Qi [Ah] to Qf [Ah], and assume that the capacity of the first feature point (pi') is Qt [Ah]. The first feature value may be calculated according to the formula "(Qt - Qi) ÷ (Qf - Qi) × 100".

As another example, the first feature value may also be calculated as the SOC of the first feature point (pi') with respect to the capacity of the second profile Rn'. As still another example, the first feature value may also be calculated as the SOC of the first feature point (pi') for the capacity of the battery profile.

Specifically, the control unit 130 may be configured to diagnose the state of the battery as a normal state or an available lithium loss state.

Here, the normal state means a state in which battery degradation occurs at a normal level. In other words, the normal state means a state in which the battery is degraded, but the degree of degradation is at a normal level. In addition, the available lithium loss state means a state in which lithium plating occurs, where lithium metal is deposited on the surface of the negative electrode of the battery.

The apparatus 100 for diagnosing a battery according to an embodiment of the present disclosure has an advantage in that the state of the battery may be specifically diagnosed based on the first profile Rp' derived using the adjustment result of the first reference profile Rp and the second reference profile Rn. That is, since the degradation pattern of the battery may be specifically diagnosed according to an embodiment of the present disclosure, the current state of the battery may be qualitatively diagnosed in a non-destructive manner.

Meanwhile, the control unit 130 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 130 may be implemented as a set of program modules. At this time, the program module may be stored in the memory and executed by the control unit 130. The memory may be inside or outside the control unit 130 and may be connected to the control unit 130 by various well-known means.

In addition, the apparatus 100 for diagnosing a battery may further include a storage unit 140. The storage unit 140 may store data necessary for operation and function of each component of the apparatus 100 for diagnosing a battery, data generated in the process of performing the operation or function, or the like. The storage unit 140 is not particularly limited in its kind as long as it is a known information storage means that can record, erase, update and read data. As an example, the information storage means may include RAM, flash memory, ROM, EEPROM, registers, and the like. In addition, the storage unit 140 may store program codes in which processes executable by the control unit 130 are defined.

Below, a specific example of the control unit 130 diagnosing the state of a battery is described.

In one embodiment, the control unit 130 may diagnose the state of the battery based on the result of comparing the first feature value and the first criterion value.

Here, the first criterion value may be preset as a first feature value of a reference battery. In addition, the reference battery is a battery that is compared with the battery according to an embodiment of the present disclosure, and refers to a battery that has undergone only normal level of degradation experimentally or theoretically.

Specifically, the first feature value may be sensitively changed when the available lithium is lost among the states of the battery. That is, whether the available lithium is lost may be confirmed based on the change in the first feature value. Accordingly, the control unit 130 may diagnose the state of the battery by comparing the size of the first criterion value and the first feature value.

For example, the control unit 130 may be configured to diagnose the state of the battery as an available lithium loss state if the first feature value exceeds a first criterion value. Conversely, the control unit 130 may be configured to diagnose the state of the battery as a normal state if the first feature value is less than or equal to the first criterion value.

In another embodiment, the control unit 130 may calculate the available lithium loss rate of the battery based on the first feature value, and diagnose the state of the battery based on the calculated available lithium loss rate.

The control unit 130 may be configured to calculate an available lithium loss rate based on a preset first reference value, a preset second reference value and the first feature value. Here, the available lithium loss rate represents the extent to which the amount of lithium that can be used for charging and discharging is lost. For example, if the available lithium loss rate is 1%, it means that 1% of the lithium that is designed to be usable is lost without being usable. In other words, 1% of the lithium that is designed to be usable may have been deposited as metal on the negative electrode of the battery.

In one embodiment, the first reference value may be preset as the SOC of the first reference point (pi0) included in the first reference profile Rp. Here, the first reference point (pi0) of the first reference profile Rp corresponds to the first feature point (pi') of the first profile Rp'. Specifically, since the first reference profile Rp corresponds to the positive electrode profile of the battery in the BOL state, the first reference point (pi0) corresponds to the positive electrode participation start point of the battery in the BOL state.

For example, in the embodiment of FIG. 2, the first reference point (pi0) of the first reference profile Rp corresponds to the first feature point (pi') of the first profile Rp'. Also, the first reference value may be calculated as the SOC of the first reference point (pi0) with respect to the capacity of the first reference profile Rp.

And, the second reference value may be preset as the SOC of the second reference point (pf0) included in the first reference profile Rp. Here, the second reference point (pf0) of the first reference profile Rp corresponds to the second feature point (pf') of the first profile Rp'. Specifically, since the first reference profile Rp corresponds to the positive electrode profile of the battery in the BOL state, the second reference point (pf0) corresponds to the positive electrode participation end point of the battery in the BOL state.

For example, in the embodiment of FIG. 2, the second reference point (pf0) of the first reference profile Rp corresponds to the second feature point (pf') of the first profile Rp'. And, the second reference value may be calculated as the SOC of the second reference point (pf0) with respect to the capacity of the first reference profile Rp.

Specifically, the control unit 130 may calculate the first difference between the first reference value and the second reference value, calculate the second difference between the first feature value and the first reference value, and calculate the ratio of the second difference to the first difference to calculate the available lithium loss rate.

For example, the control unit 130 may calculate the available lithium loss rate using Formula 1 below.

[Formula 1]

$$L_{Li} = \frac{pi_{MOL} - pi_{BOL}}{pf_{BOL} - pi_{BOL}}$$

Here, $L_{Li}$ is the available lithium loss rate, $pi_{BOL}$ is the first reference value of the first reference profile Rp, $pf_{BOL}$ is the second reference value of the first reference profile Rp, and $pi_{MOL}$ is the first feature value of the first profile Rp'.

In another embodiment, the first reference value is the SOC of the first reference point included in the first reference profile Rp and the SOC of the first reference point included in the second reference profile Rn. Specifically, since the second reference profile Rn corresponds to the negative electrode profile of the battery in the BOL state, the first reference point corresponds to the negative electrode participation start point of the battery in the BOL state.

For example, in the embodiment of FIG. 2, the first reference value may be calculated as the SOC of the first reference point (ni0) with respect to the capacity of the second reference profile Rn.

And, the second reference value is the SOC of the second reference point (nf0) included in the second reference profile Rn. Specifically, since the second reference profile Rn corresponds to the negative electrode profile of the battery in the BOL state, the second reference point (nf0) corresponds to the negative electrode participation end point of the battery in the BOL state.

For example, in the embodiment of FIG. 2, the second reference value may be calculated as the SOC of the second reference point (nf0) with respect to the capacity of the second reference profile Rn.

Specifically, the control unit 130 may calculate the first difference between the first reference value and the second reference value of the second reference profile Rn, calculate the second difference between the first feature value and the first reference value of the first reference profile Rp, and calculate the ratio of the second difference to the first difference to calculate the available lithium loss rate.

For example, the control unit 130 may calculate the available lithium loss rate using Formula 2 below.

[Formula 2]

$$L_{Li} = \frac{pi_{MOL} - pi_{BOL}}{nf_{BOL} - ni_{BOL}}$$

Here, $L_{Li}$ is the available lithium loss rate, $pi_{BoL}$ is the first reference value of the first reference profile Rp, $ni_{BOL}$ is the first reference value of the second reference profile Rn, $nf_{BOL}$ is the second reference value of the second reference profile Rn, and $pi_{MOL}$ is the first feature value of the first profile Rp'.

For example, if the first reference value of the first reference profile Rp is set to the capacity of the first reference point (pi0) for the capacity of the first reference profile Rp, the first reference value of the second reference profile Rn may also be set to the capacity of the first reference point (ni0) for the capacity of the first reference profile Rp. As another example, if the first reference value of the first reference profile Rp is set to the capacity of the first reference point (pi0) for the capacity of the second reference profile Rn, the first reference value of the second reference profile Rn may also be set to the capacity of the first reference point (ni0) for the capacity of the second reference profile Rn. That is, since the difference in the capacities of the first reference point and the second reference point of the first reference profile Rp is the same as the difference in the capacities of the first reference point and the second reference point of the second reference profile Rn, the difference between the first reference value and the second reference value of the first reference profile Rp is the same as the difference between the first reference value and the second reference value of the second reference profile Rn. That is, in Formula 1 and Formula 2, "$pf_{BOL} - pi_{BOL}$" may be replaced with "$nf_{BOL} - ni_{BOL}$".

In the embodiment of FIG. 2, the capacity difference between the first reference point (pi0) and the second reference point (pf0) of the first reference profile Rp is equal to the capacity difference between the first reference point (ni0) and the second reference point (nf0) of the second reference profile Rn. Therefore, the difference ($pf_{BOL} - pi_{BOL}$) between the first reference value and the second reference value of the first reference profile Rp is equal to the difference ($nf_{BOL} - ni_{BOL}$) between the first reference value and the second reference value of the second reference profile Rn.

The control unit 130 may be configured to compare the calculated available lithium loss rate with a preset second criterion value.

Specifically, the second criterion value may be preset as the available lithium loss rate of the reference battery. As described above, the reference battery is a battery that is compared with the battery according to an embodiment of the present disclosure and means a battery that has undergone only normal degradation experimentally or theoretically. For example, the available lithium loss rate of the reference battery may be calculated based on the first reference value, the second reference value and the first feature value of the reference battery, and the calculated available lithium loss rate may be set as the second criterion value. As another example, the available lithium loss rate of the reference battery may be calculated by directly measuring the amount of lithium metal precipitated on the negative electrode surface of the reference battery, and the calculated available lithium loss rate may be set as the second criterion value.

The control unit 130 may be configured to diagnose the state of the battery based on the comparison result.

For example, the control unit 130 may be configured to diagnose the state of the battery as an available lithium loss state if the available lithium loss rate exceeds the second criterion value. Conversely, the control unit 130 may be configured to diagnose the state of the battery as a normal state if the available lithium loss rate is less than or equal to the second criterion value. That is, the control unit 130 may diagnose the state of the battery as an available lithium loss state if the available lithium loss rate of the battery is greater than the available lithium loss rate of the reference battery.

In another embodiment, the control unit 130 may diagnose the state of the battery by considering both the result of comparing the first feature value with the first criterion value and the result of comparing the available lithium loss rate of the battery with the second criterion value.

The control unit 130 may diagnose the state of the battery by considering the first result of comparing the first feature value and the first criterion value and the second result of comparing the available lithium loss rate of the battery and the second criterion value.

For example, if both the first result and the second result are normal states, the control unit 130 may diagnose the state of the battery as a normal state.

As another example, the control unit 130 may diagnose the state of the battery as an available lithium loss state if both the first result and the second result are the available lithium loss state.

As still another example, the control unit 130 may diagnose the state of the battery as an available lithium loss state if the first result and the second result are different from each other and the second result is the available lithium loss state.

As still another example, the control unit 130 may diagnose the state of the battery as a pending state if the first result and the second result are different from each other and the second result is a normal state. The control unit 130 may determine that the state of the battery is not an available lithium loss state but a state that requires additional diagnosis. In this case, a diagnostic trouble code (DTC), flag, message, or log, etc., indicating that another diagnosis of the battery is required, may be recorded.

FIG. 3 is a graph referenced to explain an example of each of the first reference profile and the second reference profile. In the graph of FIG. 3, the horizontal axis (X-axis) represents capacity (Ah) and the vertical axis (Y-axis) represents voltage (V).

Referring to FIG. 3, the storage unit 140 may store a first reference profile $Rp$ and a second reference profile $Rn$. The reference cell may be a coin type cell including a positive electrode half cell and a negative electrode half cell, or a 3-electrode cell.

The first reference profile $Rp$ may be a profile representing the corresponding relationship between the positive electrode voltage and capacity of the reference cell. The positive electrode voltage of the reference cell refers to the potential difference between the potential of the reference electrode (not shown) and the potential of the positive electrode of the reference cell.

The second reference profile $Rn$ may be a profile representing the corresponding relationship between the negative electrode voltage and capacity of the reference cell. The negative electrode voltage of the reference cell refers to the potential difference between the potential of the reference electrode and the potential of the negative electrode of the reference cell.

The positive electrode voltage and the negative electrode voltage may each be a closed circuit voltage or an open circuit voltage (OCV).

A first charging protocol or a first discharging protocol may be utilized to obtain the closed circuit voltages of the positive electrode and the negative electrode of the reference cell, respectively. The first charging protocol may be a constant current charging method using the first current rate. The first discharging protocol may be a constant current discharging method using the first current rate. For example, while the reference cell is continuously charged by the first charging protocol or while the reference cell is continuously discharged by the first discharging protocol, the closed circuit voltages of the positive electrode and the negative electrode of the reference cell, which are measured periodically or non-periodically, may be recorded as the positive electrode voltage and the negative electrode voltage of the reference cell.

The second charging protocol or the second discharging protocol may be used to obtain the open circuit voltage of each of the positive electrode and the negative electrode of the reference cell. The second charging protocol may be an intermittent charging method in which constant current charging using the second current rate and pause are alternately performed. The second discharging protocol may be an intermittent charging method in which constant current discharging using the second current rate and pause are alternately performed. The second current rate (e.g., 3.0 C) may be predetermined to be greater than the first current rate (e.g., 0.05 C).

For example, when the charging time by constant current charging of the second charging protocol elapses by a set time or the charge capacity of the reference cell increases by a set capacity, the charging of the reference cell may be stopped for a predetermined pause time and then the constant current charging may be resumed. The charge capacity may be calculated by periodically or aperiodically accumulating the sample values of the charge current by the first charging protocol or the second charging protocol.

As another example, when the discharging time by the constant current discharging of the second discharging protocol elapses by a set time or the discharge capacity of the reference cell decreases by a set capacity, the discharging of the reference cell may be stopped for a predetermined pause time and then the constant current discharging may be resumed. The discharge capacity may be calculated by periodically or aperiodically accumulating the sample values of the discharge current by the first discharging protocol or the second discharging protocol.

At this time, the open circuit voltage of each of the positive electrode and the negative electrode of the reference cell measured at a specific timing for each pause may be recorded as the positive electrode voltage and the negative electrode voltage of the reference cell.

For convenience of explanation, it is assumed that the horizontal axis represents the charging capacity in FIGS. 3 to 10.

At least one of the first reference profile $Rp$ and the second reference profile $Rn$ may be aligned along the horizontal axis so that the result of synthesizing a portion (5 to 50 Ah in FIG. 3) of the common capacity range of the two profiles $Rp$ and $Rn$ matches the third reference profile $R$. FIG. 3 illustrates an example of a case in which the second reference profile $Rn$ is aligned by shifting to the right, with the start point (the point corresponding to capacity 0) of the first reference profile $Rp$ as a reference point.

It may be confirmed from FIG. 3 that both ends of the first reference profile $Rp$ and the second reference profile $Rn$ are misaligned. That is, the capacity range of the first reference profile $Rp$ and the capacity range of the second reference profile Rn do not match and only partially overlap. Therefore, the third reference profile R represents the full cell voltage of the reference cell in a part of the capacity range common to the first reference profile Rp and the second reference profile Rn. That is, the third reference profile R is an example of a full cell voltage profile obtained by directly subtracting a part of the second reference profile Rn from a part of the first reference profile Rp.

The third reference profile R may represent the corresponding relationship between the capacity and the full cell voltage of a new battery cell that has been verified as good. That is, the reference cell has the same level of positive electrode performance and negative electrode performance as a new battery cell that has been verified as good.

The third reference profile R may represent the corresponding relationship between the voltage and capacity of the reference cell over at least the voltage range of interest (e.g., 3.0 to 4.0 V). The lower and upper limits of the voltage range of interest may be the first set voltage (3.0 V in FIG. 3) and the second set voltage (4.0 V in FIG. 3).

The SOC may be set to 0% when the full cell voltage of any battery cell including the reference cell is equal to the first set voltage. The SOC may be set to 100% when the full cell voltage of any battery cell including the reference cell is equal to the second set voltage. According to FIG. 3, the reference cell may reach a fully charged state (SOC 100%) from a fully discharged state (SOC 0%) by a charge capacity of 45 Ah.

In the present specification, the positive electrode participation start point on the positive electrode profile of any battery cell represents the positive electrode voltage when the full cell voltage of the corresponding battery cell matches the first set voltage. In addition, the negative electrode participation start point on the negative electrode profile of the corresponding battery cell represents the negative electrode voltage when the full cell voltage of the corresponding battery cell matches the first set voltage. Therefore, the voltage difference between the positive electrode participation start point and the negative electrode participation start point is equal to the first set voltage.

In addition, the positive electrode participation end point on the positive electrode profile of any battery cell represents the positive electrode voltage when the full cell voltage of the corresponding battery cell matches the second set voltage. In addition, the negative electrode participation end point on the negative electrode profile of the corresponding battery cell represents the negative electrode voltage when the full cell voltage of the corresponding battery cell matches the second set voltage. Therefore, the voltage difference between the positive electrode participation end point and the negative electrode participation end point is equal to the second set voltage.

In the storage unit 140, information indicating the voltage of each of the reference positive electrode participation start point (pi0), the reference positive electrode participation end point (pf0), the reference negative electrode participation start point (ni0), and the reference negative electrode participation end point (nf0) may be pre-recorded. The reference positive electrode participation start point (pi0) and the reference positive electrode participation end point (pf0) are the positive electrode participation start point and the positive electrode participation end point on the first reference profile Rp, respectively. The reference negative electrode participation start point (ni0) and the reference negative electrode participation end point (nf0) are the negative electrode participation start point and the negative electrode participation end point, respectively, on the second reference profile Rn.

The voltage difference between the reference positive electrode participation start point (pi0) and the reference negative electrode participation start point (ni0) may be equal to the first set voltage (e.g., 3.0 V). The voltage difference between the reference positive electrode participation end point (pfD) and the reference negative electrode participation end point (nf0) may be equal to the second set voltage (e.g., 4.0 V).

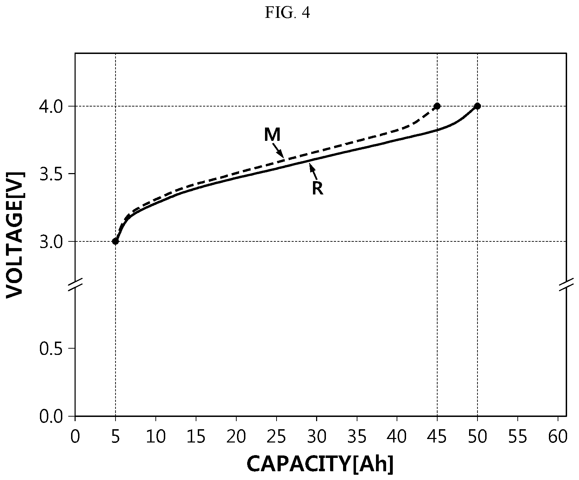

FIG. 4 is a graph referenced to explain an example of a battery profile of a target cell. In the graph of FIG. 4, the horizontal axis (X-axis) represents capacity (Ah) and the vertical axis (Y-axis) represents voltage.

Referring to FIG. 4, the profile adjusting unit 120 may generate a battery profile M representing a corresponding relationship between the capacity of a battery cell to be diagnosed (hereinafter, referred to as a 'target cell') and the terminal voltage (also referred to as 'full cell voltage'). Here, the terminal voltage refers to a voltage across both ends of the target cell (CCV or OCV), and is distinguished from the positive electrode voltage and negative electrode voltage described above. In other words, the terminal voltage of the target cell may be said to be the difference between the positive electrode voltage and the negative electrode voltage of the target cell.

The first charging protocol, the first discharging protocol, the second charging protocol, or the second discharging protocol described above may be used to generate the battery profile M. Like the third reference profile R, the battery profile M may represent the corresponding relationship between the voltage and the capacity of the target cell at least over the voltage range of interest (e.g., 3.0 to 4.0 V).

If the first reference profile Rp and the second reference profile Rn are obtained by the first charging protocol (or the first discharging protocol), the battery profile M may also be based on the voltage time series and capacity time series collected through the charging procedure (or the discharging procedure) by the first charging protocol (or the first discharging protocol).

If the first reference profile Rp and the second reference profile Rn are obtained by the second charging protocol (or the second discharging protocol), the battery profile M may also be based on the voltage time series and capacity time series collected through the charging procedure (or discharging procedure) by the second charging protocol (or the second discharging protocol).

The voltage time series represents the temporal change in the terminal voltage of the target cell. The capacity time series represents the temporal change in the capacity of the target cell while the target cell is being charged or discharged by the first charging protocol, the first discharging protocol, the second charging protocol, or the second discharging protocol.

When compared with the third reference profile R described above with reference to FIG. 3, the battery profile M may represent an actual corresponding relationship between the capacity of the target cell and the full cell voltage. The target cell may be a new battery cell that needs to be verified as good or a battery cell that has deteriorated after being verified as good and is no longer new.

Accordingly, as illustrated in FIG. 4, there may be some difference between the battery profile M and the third reference profile R. For example, the voltage of the battery profile M is higher than the voltage of the third reference profile R at the same capacity value, which is caused by a manufacturing defect of the target cell, loss of positive electrode capacity, loss of negative electrode capacity, and/or loss of available lithium. It is obvious that as the target cell deteriorates through repeated charge and discharge, the difference between the battery profile M and the third reference profile R will gradually increase. According to FIG. 4, unlike the reference cell described with reference to FIG. 3, a charge capacity of 40 Ah is required for the target cell to reach a fully charged state (SOC 100%) from a fully discharged state (SOC 0%), which is 5 Ah less than the charge capacity required for fully charging the reference cell.

Meanwhile, in the embodiments of FIGS. 3 and 4, Ah is used as the unit of the horizontal axis, but this unit may be expressed in a different form. For example, instead of Ah, a percentage % indicating SOC (State Of Charge) may be used as the unit of the horizontal axis.

When the battery profile M is generated, the profile adjusting unit 120 may be configured to compare the battery profile M with at least one comparison profile. Here, the comparison profile may be a result of adjusting the first reference profile Rp and the second reference profile Rn stored in the storage unit 140 to generate the first adjusted profile and the second adjusted profile, and then synthesizing (combining) the first adjusted profile and the second adjusted profile. Here, the first adjusted profile is a result of adjusting the first reference profile Rp and is an adjusted positive electrode profile. The second adjusted profile is a result of adjusting the second reference profile Rn and is an adjusted negative electrode profile.

That is, when the third reference profile R is the result of subtracting a part of the second reference profile Rn from a part of the first reference profile Rp, the comparison profile may be said to be the result of subtracting a part of the second adjusted profile from a part of the first adjusted profile.

The profile adjusting unit 120 may generate at least one comparison profile by directly adjusting the first reference profile Rp and the second reference profile Rn. Alternatively, the at least one comparison profile may be secured in advance based on the first reference profile Rp and the second reference profile Rn and stored in the storage unit 140. In this case, the profile adjusting unit 120 may also obtain the comparison profile by accessing the storage unit 140 and reading it.

The profile adjusting unit 120 may generate a plurality of comparison profiles from the first reference profile Rp and the second reference profile Rn by repeating the adjusting procedure of adjusting each of the first reference profile Rp and the second reference profile Rn to several levels and then synthesizing them.

The profile adjusting unit 120 may specify any one comparison profile among a plurality of comparison profiles, which has a minimum error with respect to the battery profile M. Then, the profile adjusting unit 120 may determine that a first adjusted profile and a second adjusted profile mapped to the specified comparison profile are the first profile and the second profile of the target cell. Here, the first profile is estimated as the positive electrode profile of the target cell, and the second profile is estimated as the negative electrode profile of the target cell.

In relation to this, various methods known at the time of filing of the present disclosure may be employed to determine the error between two profiles, each of which may be expressed in a two-dimensional coordinate system. For example, the integral of the absolute value of the area between the two profiles or the RMSE (Root Mean Square Error) may be used as the error between the two profiles.

According to this configuration of the present disclosure, various state information about the target cell may be obtained based on the finally determined first profile and second profile. The finally determined first profile and second profile may be mapped to a comparison profile mapped with a minimum error. In particular, the comparison profile by the finally determined first profile and second profile may be said to have a shape, etc. almost identical to that of the battery profile M.

Therefore, according to the present disclosure, the positive electrode profile and negative electrode profile for the target cell may be obtained even without disassembling the target cell or manufacturing it in the form of a 3-electrode cell.

If the target cell is a new battery cell, the first profile and second profile may be analyzed to more easily diagnose whether a defect has occurred in the target cell and, if so, what type of defect it is.

If the target cell is a battery cell in use after it has been verified as a good product, the degree to which the target cell has deteriorated may be identified by degradation item through the first profile and second profile.

Furthermore, according to an embodiment of the present disclosure, the positive electrode profile (first profile) and the negative electrode profile (second profile) of the target cell may be obtained in a simple manner. The present disclosure may be implemented even if only one first reference profile Rp and one second reference profile Rn are stored in the storage unit 140. That is, there is no need to store a plurality of first reference profiles Rp and/or a plurality of second reference profiles Rn in the storage unit 140. Accordingly, there is no need for the storage capacity of the storage unit 140 to be high, and there is no need to proceed with a large number of preliminary tests required to secure a plurality of first reference profiles Rp and/or a plurality of second reference profiles Rn.

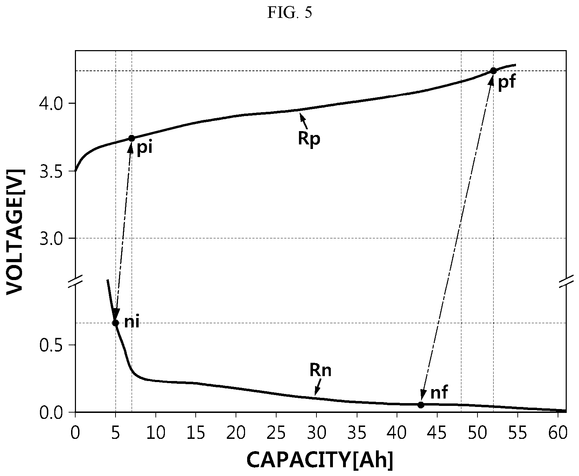

FIGS. 5 to 7 are drawings referenced to explain an example of a procedure for generating a comparison profile used for comparison with the battery profile according to an embodiment of the present disclosure.

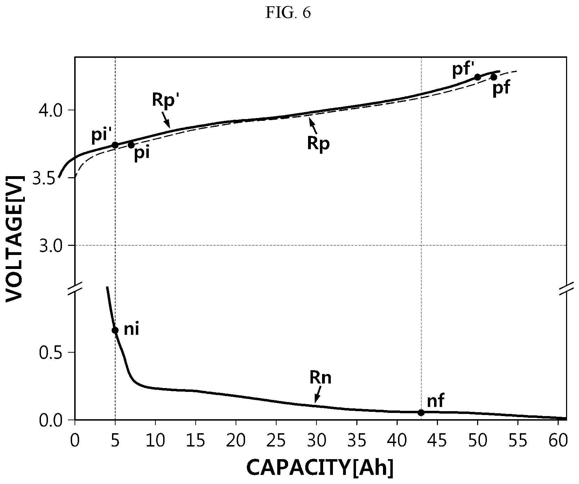

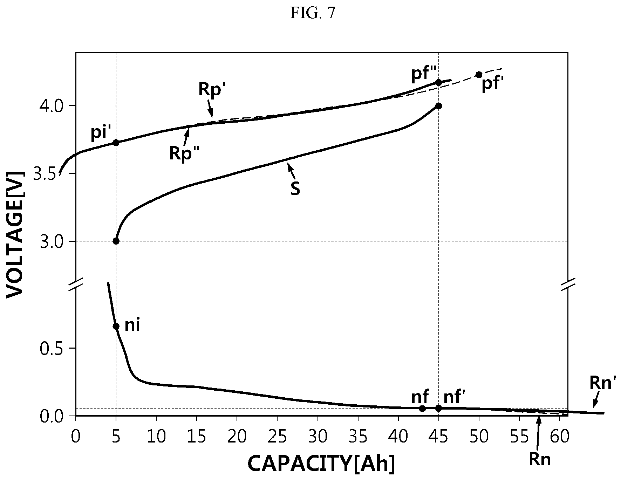

The generation procedure of the comparison profile to be described with reference to FIGS. 5 to 7 is performed in the order of a first routine (see FIG. 5) that sets four points (positive electrode participation start point, positive electrode participation end point, negative electrode participation start point, negative electrode participation end point) to correspond to a voltage range of interest, a second routine (see FIG. 6) that performs profile shifting, and a third routine (see FIG. 7) that performs capacity scaling. That is, the generation procedure of the comparison profile according to an embodiment of the present disclosure includes the first to third routines.

First, referring to FIG. 5, the first reference profile Rp and the second reference profile Rn are the same as those shown in FIG. 3.

The profile adjusting unit 120 determines the positive electrode participation start point (pi), the positive electrode participation end point (pf), the negative electrode participation start point (ni), and the negative electrode participation end point (nf) on the first reference profile Rp and the second reference profile Rn.

Either the positive electrode participation start point (pi) or the negative electrode participation start point (ni) depends on the other.

For example, the profile adjusting unit 120 may divide the positive electrode voltage range from a start point to an end point (or a second set voltage) of the first reference profile Rp into a plurality of micro voltage sections, and then set a boundary point of two adjacent micro voltage sections among the plurality of micro voltage sections as the positive electrode participation start point (pi). Each micro voltage section may have a predetermined size (e.g., 0.01 V). Then, the profile adjusting unit 120 may set a point on the second reference profile Rn that is smaller than the positive electrode participation start point (pi) by the first set voltage (e.g., 3 V) as the negative electrode participation start point (ni).

As another example, the profile adjusting unit 120 may divide the negative electrode voltage range from the start point to the end point of the second reference profile Rn into a plurality of micro voltage sections of a predetermined size, and then set a boundary point of two adjacent micro voltage sections among the plurality of micro voltage sections as the negative electrode participation start point (ni). Then, the profile adjusting unit 120 may search for a point that is larger than the negative electrode participation start point (ni) by a first set voltage from the first reference profile Rp, and set the searched point as the positive electrode participation start point (pi).

Either the positive electrode participation end point (pf) or the negative electrode participation end point (nf) depends on the other.

For example, the profile adjusting unit 120 may divide the voltage range from the second set voltage to the end point of the first reference profile Rp into a plurality of micro voltage sections of a predetermined size, and then set a boundary point of two adjacent micro voltage sections among the plurality of micro voltage sections as the positive electrode participation end point (pf). Then, the profile adjusting unit 120 may set a point on the second reference profile Rn that is smaller by the second set voltage (e.g., 4 V) than the positive electrode participation end point (pf) as the negative electrode participation end point (nf).

As another example, the profile adjusting unit 120 may divide the negative electrode voltage range from the start point to the end point of the second reference profile Rn into a plurality of micro voltage sections of a predetermined size, and then set a boundary point of two adjacent micro voltage sections among the plurality of micro voltage sections as the negative electrode participation end point (nf). Then, the profile adjusting unit 120 may search for a point larger than the negative electrode participation end point (nf) by the second set voltage from the first reference profile Rp, and set the searched point as the positive electrode participation end point (pf).

Once the determination of the positive electrode participation start point (pi), the positive electrode participation end point (pf), the negative electrode participation start point (ni), and the negative electrode participation end point (nf) is completed, the profile adjusting unit 120 shifts at least one of the first reference profile Rp and the second reference profile Rn to the left or right along the horizontal axis.

Referring to FIG. 6, the profile adjusting unit 120 may shift the first reference profile Rp to the left (low capacity side), shift the second reference profile Rn to the right (high capacity side), or both, so that the capacity values of the positive electrode participation start point (pi) and the negative electrode participation start point (ni) match.

Alternatively, the profile adjusting unit 120 may shift the first reference profile Rp to the left, shift the second reference profile Rn to the right, or both, so that the voltages of the positive electrode participation end point (pf) and the negative electrode participation end point (nf) match.

FIG. 6 illustrates a situation in which only the first reference profile Rp is shifted to the left to generate an adjusted first reference profile Rp', and as a result, the voltage of the positive electrode participation start point (pi') matches the voltage of the negative electrode participation start point (ni). The adjusted first reference profile Rp' is the result of applying the adjusting procedure for shifting to the left by the voltage difference between the positive electrode participation start point (pi) and the negative electrode participation start point (ni) to the first reference profile Rp. Therefore, the two points (pi, pi') differ only in the capacity value, and the voltage is the same. The two points (pf, pf') differ only in the capacity value, and the voltage is the same.

When the adjustment result profiles Rp', Rn in which at least one of the first reference profile Rp and the second reference profile Rn is shifted are obtained, the profile adjusting unit 120 scales the capacity range of at least one of the adjustment result profiles Rp', Rn.

According to the example illustrated in FIG. 6, the profile adjusting unit 120 performs an additional adjusting procedure of contracting or expanding at least one of the adjusted first reference profile Rp' and the second reference profile Rn along the horizontal axis.

Referring to FIG. 7, the profile adjusting unit 120 may generate an adjusted first reference profile Rp" by shrinking or expanding the adjusted first reference profile Rp' so that the size of the capacity range between two points (pi', pf') of the adjusted first reference profile Rp' matches the size of the capacity range of the battery profile M. At this time, one of the two points (pi', pf') may be fixed. Accordingly, the capacity difference between the two points (pi', pf") of the adjusted first reference profile Rp" may match the capacity range of the battery profile M.

In addition, the profile adjusting unit 120 may generate an adjusted second reference profile Rn' by shrinking or expanding the second reference profile Rn so that the size of the capacity range between two points (ni, nf) of the second reference profile Rn matches the size of the capacity range of the battery profile M. At this time, one of the two points (ni, nf) may be fixed. Accordingly, the capacity difference between the two points (ni, nf') of the adjusted second reference profile Rn' may match the capacity range of the battery profile M.

In FIG. 7, the adjusted first reference profile Rp" is a result of contracting the adjusted first reference profile Rp' shown in FIG. 6, and the adjusted second reference profile Rn' is a result of expanding the second reference profile Rn shown in FIG. 6.

The positive electrode participation end point (pf") on the adjusted first reference profile Rp" corresponds to the positive electrode participation end point (pf') on the adjusted first reference profile Rp'. The negative electrode participation end point (nf') on the adjusted second reference profile Rn' corresponds to the negative electrode participation end point (nf) on the second reference profile Rn.

The capacity difference between the positive electrode participation start point (pi') and the positive electrode participation end point (pf") of the adjusted first reference profile Rp" corresponds to the size of the capacity range of the battery profile M. Similarly, the capacity difference between the negative electrode participation start point (ni) and the negative electrode participation end point (nf') of the adjusted second reference profile Rn' corresponds to the size of the capacity range of the battery profile M.

In addition, the capacity range by the two points (pi', pf") of the adjusted first reference profile Rp" matches the capacity range by the two points (ni, nf') of the adjusted second reference profile Rn'. The profile adjusting unit 120 may generate a comparison profile S by subtracting the profile between the two points (pi', pf") of the adjusted first reference profile Rp" from the profile between the two points (ni, nf') of the adjusted second reference profile Rn'.

The profile adjusting unit 120 may calculate the error (profile error) between the comparison profile S and the third reference profile R.

The profile adjusting unit 120 may map at least two of the adjusted first reference profile Rp", the adjusted second reference profile Rn', the positive electrode participation start point (pi'), the positive electrode participation end point (pf"), the negative electrode participation start point (ni), the negative electrode participation end point (nf'), the first scale factor, the second scale factor, the comparison profile S, and the profile error to each other, and record them in the storage unit 140.

The first scale factor may represent the ratio of the capacity difference between the two points (pi', pf") to the capacity difference between the two points (pi0, pf0). The second scale factor may represent the ratio of the capacity difference between the two points (ni, nf') to the capacity difference between the two points (ni0, nf0). That is, the first scale factor is the change ratio of the adjusted first reference profile Rp" to the first reference profile Rp, which is the positive electrode change ratio. The second scale factor is the change ratio of the adjusted second reference profile Rn' to the second reference profile Rn, which is the negative electrode change ratio.

Meanwhile, as described above, when the positive electrode voltage range of the first reference profile Rp is divided into a plurality of micro voltage sections, the boundary point of two adjacent micro voltage sections among the plurality of micro voltage sections may be set as the positive electrode participation start point (pi).

For example, if the positive electrode voltage range of the first reference profile Rp is divided into 100 micro voltage ranges, the number of boundary points that can be set as the positive electrode participation start point (pi) may be 100. In addition, if the voltage range higher than or equal to the second set voltage in the first reference profile Rp is divided into 40 micro voltage ranges, the number of boundary points that can be set as the positive electrode participation end point (pf) may be 40. In this case, a maximum of 4000 different comparison profiles may be generated.

Of course, those skilled in the art will easily understand that as the size of the micro voltage section decreases, the maximum number of comparison profiles that can be generated increases, and conversely, as the size of the micro voltage section increases, the maximum number of comparison profiles that can be generated decreases.

The profile adjusting unit 120 may identify a minimum among profile errors of a plurality of comparison profiles generated as described above, and then obtain information mapped to the minimum profile error (e.g., at least one of the positive electrode participation start point, the positive electrode participation end point, the negative electrode participation start point, the negative electrode participation end point, the first scale factor, and the second scale factor) from the storage unit 140.

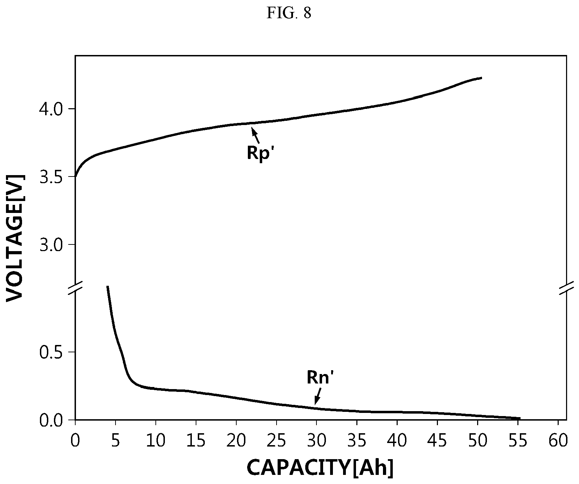

FIGS. 8 to 10 are drawings referenced to explain another example of the procedure for generating a comparison profile used for comparison with the battery profile according to an embodiment of the present disclosure. For reference, the embodiment according to FIGS. 8 to 10 is independent of the embodiment according to FIGS. 5 to 7. Therefore, terms or symbols commonly described in describing the embodiment according to FIGS. 5 to 7 and the embodiment according to FIGS. 8 to 10 should be understood as being limited to each embodiment.

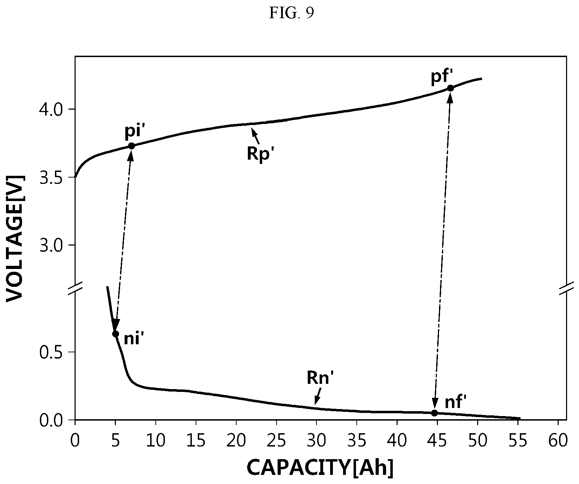

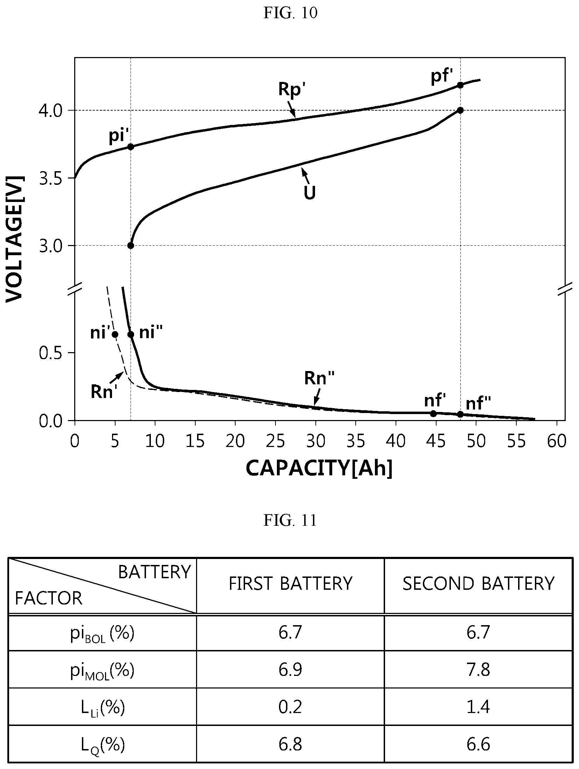

The generation procedure of the comparison profile to be described with reference to FIGS. 8 to 10 is performed in the order of a fourth routine (see FIG. 8) for performing capacity scaling, a fifth routine (see FIG. 9) for setting four points (positive electrode participation start point, positive electrode participation end point, negative electrode participation start point, negative electrode participation end point), and a sixth routine (see FIG. 10) for performing profile shifting. That is, the generation procedure of the comparison profile according to another embodiment of the present disclosure includes the fourth to sixth routines.

Referring to FIG. 8, the first reference profile Rp and the second reference profile Rn are the same as those shown in FIG. 3.

The profile adjusting unit 120 applies a first scale factor and a second scale factor selected from a scaling value range to the first reference profile Rp and the second reference profile Rn, respectively, to generate an adjusted first reference profile Rp' and an adjusted second reference profile Rn'.

The scaling value range may be predetermined or may vary depending on the ratio of the size of the capacity range of the battery profile M to the size of the capacity range of the third reference profile R. For example, when values spaced at 0.1% intervals (i.e., 90%, 90.1%, 90.2%, ..., 98.9%, 99%) of the scaling value range (e.g., 90 to 99%) may be selected as the first scale factor and the second scale factor, 91 values may be selected as the first scale factor and the second scale factor, respectively. In this case, a maximum of 8,281 adjusted profile pairs may be generated according to 8,281 (91 × 91) adjustment levels (combinations of the first scale factor and the second scale factor). An adjusted profile pair means a combination of the first adjusted profile and the second adjusted profile.

The adjusted first reference profile Rp' and the adjusted second reference profile Rn' illustrated in FIG. 8 illustrate the results of applying a first scale factor and a second scale factor of less than 100% to the first reference profile Rp and the second reference profile Rn, respectively.

Since the first scale factor and the second scale factor are less than 100%, the adjusted first reference profile Rp' is the first reference profile Rp shrunk along the horizontal axis, and the adjusted second reference profile Rn' is also the second reference profile Rn shrunk along the horizontal axis. To help understanding, the start points of the first reference profile Rp and the second reference profile Rn are fixed, and the remaining portion is shrunk to the left along the horizontal axis as an example.

In the above examples, the scale factor is described as being less than 100%, but the scale factor may be greater than or equal to 100%.

Referring to FIG. 9, the profile adjusting unit 120 determines a positive electrode participation start point (pi'), a positive electrode participation end point (pf'), a negative electrode participation start point (ni'), and a negative electrode participation end point (nf') on the adjusted first reference profile Rp' and the adjusted second reference profile Rn'.

Either the positive electrode participation start point (pi') and the negative electrode participation start point (ni') may depend on the other. Furthermore, either the positive electrode participation end point (pf') and the negative electrode participation end point (nf') may depend on the other. Furthermore, either the positive electrode participation start point (pi') and the positive electrode participation end point (pf') may be set based on the other.

That is, when one of the positive electrode participation start point (pi'), the positive electrode participation end point (pf'), the negative electrode participation start point (ni'), and the negative electrode participation end point (nf') is set, the remaining three points may be automatically set by the first set voltage, the second set voltage, and/or the size of the capacity range of the battery profile M (e.g., the charge capacity of SOC 0 to 100%).

For example, the profile adjusting unit 120 may divide the positive electrode voltage range from a start point to an end point (or a second set voltage) of the adjusted first reference profile Rp' into a plurality of micro voltage sections, and then set a boundary point of two adjacent micro voltage sections among the plurality of micro voltage sections as the positive electrode participation start point (pi'). Then, the profile adjusting unit 120 may set a point on the adjusted second reference profile Rn, which is smaller than the positive electrode participation start point (pi') by the first set voltage (e.g., 3 V), as the negative electrode participation start point (ni').

As another example, the profile adjusting unit 120 may divide the negative electrode voltage range from the start point to the end point of the adjusted second reference profile Rn' into a plurality of micro voltage sections of a predetermined size, and then set a boundary point of two adjacent micro voltage sections among the plurality of micro voltage sections as the negative electrode participation start point (ni'). Then, the profile adjusting unit 120 may search for a point larger than the negative electrode participation start point (ni') by the first set voltage from the adjusted first reference profile Rp', and set the searched point as the positive electrode participation start point (pi').

As still another example, the profile adjusting unit 120 may divide the voltage range from the second set voltage to the end point of the adjusted first reference profile Rp' into a plurality of micro voltage sections of a predetermined size, and then set a boundary point of two adjacent micro voltage sections among the plurality of micro voltage sections as the positive electrode participation end point (pf'). Then, the profile adjusting unit 120 may search for a point in the adjusted second reference profile Rn' that is smaller than the positive electrode participation end point (pf') by the second set voltage (e.g., 4 V), and set the searched point as the negative electrode participation end point (nf').

As still another example, the profile adjusting unit 120 may divide the negative electrode voltage range from the start point to the end point of the adjusted second reference profile Rn' into a plurality of micro voltage sections of a predetermined size, and then set a boundary point of two adjacent micro voltage sections among the plurality of micro voltage sections as the negative electrode participation end point (nf'). Then, the profile adjusting unit 120 may search for a point larger than the negative electrode participation end point (nf') by the second set voltage from the adjusted first reference profile Rp', and set the searched point as the positive electrode participation end point (pf').

If one of the positive electrode participation start point (pi'), the positive electrode participation end point (pf'), the negative electrode participation start point (ni'), and the negative electrode participation end point (nf') is determined, the profile adjusting unit 120 may additionally determine the remaining three points based on the determined point.

For example, if the positive electrode participation start point (pi') is determined first, the profile adjusting unit 120 may set a point on the adjusted first reference profile Rp', which has a capacity value larger by the size of the capacity range of the battery profile M than the capacity value of the positive electrode participation start point (pi'), as the positive electrode participation end point (pf'). In addition, the profile adjusting unit 120 may search for a point lower by the first set voltage than the positive electrode participation start point (pi') from the adjusted second reference profile Rn', and set the searched point as the negative electrode participation start point (ni'). In addition, the profile adjusting unit 120 may set a point on the adjusted second reference profile Rn', which has a capacity value larger by the size of the capacity range of the battery profile M than the capacity value of the negative electrode participation start point (ni'), as the negative electrode participation end point (nf').

As another example, if the positive electrode participation end point (pf') is determined first, the profile adjusting unit 120 may set a point on the adjusted first reference profile Rp', which has a capacity value smaller than the capacity value of the positive electrode participation end point (pf') by the size of the capacity range of the battery profile M, as the positive electrode participation start point (pi'). In addition, the profile adjusting unit 120 may search for a point lower than the positive electrode participation end point (pf') by the second set voltage from the adjusted second reference profile Rn', and set the searched point as the negative electrode participation end point (nf'). In addition, the profile adjusting unit 120 may set a point on the adjusted second reference profile Rn', which has a capacity value smaller than the capacity value of the negative electrode participation end point (nf') by the size of the capacity range of the battery profile M, as the negative electrode participation start point (ni').

As still another example, if the negative electrode participation start point (ni') is determined, the profile adjusting unit 120 may set a point on the adjusted second reference profile Rn', which has a capacity value larger than the capacity value of the negative electrode participation start point (ni') by the size of the capacity range of the battery profile M, as the negative electrode participation end point (nf'). In addition, the profile adjusting unit 120 may search for a point higher than the negative electrode participation start point (ni') by the first set voltage from the adjusted first reference profile Rp', and set the searched point as the positive electrode participation start point (pi'). In addition, the profile adjusting unit 120 may set a point on the adjusted first reference profile Rp', which has a capacity value larger than the capacity value of the positive electrode participation start point (pi') by the size of the capacity range of the battery profile M, as the positive electrode participation end point (pf').

As still another example, if the negative electrode participation end point (nf') is determined, the profile adjusting unit 120 may set a point on the adjusted second reference profile Rn', which has a capacity value smaller than the capacity value of the negative electrode participation end point (nf') by the size of the capacity range of the battery profile M, as the negative electrode participation start point (ni'). In addition, the profile adjusting unit 120 may search for a point higher than the negative electrode participation end point (nf') by the second set voltage from the adjusted first reference profile Rp', and set the searched point as the positive electrode participation end point (pf'). In addition, the profile adjusting unit 120 may set a point on the adjusted first reference profile Rp', which has a capacity value smaller than the capacity value of the positive electrode participation end point (pf') by the size of the capacity range of the battery profile M, as the positive electrode participation start point (pi').

When the determination of the positive electrode participation start point (pi'), the positive electrode participation end point (pf'), the negative electrode participation start point (ni'), and the negative electrode participation end point (nf') is completed based on the pair of the first scale factor and the second scale factor, the profile adjusting unit 120 may shift at least one of the adjusted first reference profile Rp' and the adjusted second reference profile Rn' to the left or right along the horizontal axis so that the capacity values of the positive electrode participation start point (pi') and the negative electrode participation start point (ni') match, or so that the capacity values of the positive electrode participation end point (pf') and the negative electrode participation end point (nf') match.

The adjusted second reference profile Rn" illustrated in FIG. 10 is only the adjusted second reference profile Rn' illustrated in FIG. 9 shifted to the right. Accordingly, the capacity values of the positive electrode participation start point (pi') and the negative electrode participation start point (ni") match each other. In this regard, since the capacity difference between the positive electrode participation start point (pi') and the positive electrode participation end point (pf') is the same as the capacity difference between the negative electrode participation start point (ni') and the negative electrode participation end point (nf'), when the capacity values of the positive electrode participation start point (pi') and the negative electrode participation start point (ni") match each other, the capacity values of the positive electrode participation end point (pf') and the negative electrode participation end point (nf') also match each other.

Referring to FIG. 10, the profile adjusting unit 120 may generate a comparison profile U by subtracting a partial profile between two points (pi', pf') of the adjusted first reference profile Rp' from a partial profile between two points (ni", nf") of the adjusted second reference profile Rn".

The profile adjusting unit 120 may calculate the error (profile error) between the comparison profile U and the third reference profile R.

The profile adjusting unit 120 may map at least two of the adjusted first reference profile Rp', the adjusted second reference profile Rn", the positive electrode participation start point (pi'), the positive electrode participation end point (pf'), the negative electrode participation start point (ni"), the negative electrode participation end point (nf"), the first scale factor, the second scale factor, the comparison profile U, and the profile error to each other, and record them in the storage unit 140.

As described above, the profile adjusting unit 120 may generate a comparison profile corresponding to each pair of the first scale factor and the second scale factor selected from the scaling value range. Since there are multiple pairs of the first scale factor and the second scale factor, it is obvious that multiple comparison profiles will also be generated. The profile adjusting unit 120 may identify a minimum among profile errors of the plurality of comparison profiles, and then obtain information mapped to the minimum profile error from the storage unit 140.

FIG. 11 is a drawing referenced to explain the difference between a first battery and a second battery.

The first battery is a reference battery, and the second battery is a battery that has lost available lithium. Specifically, the second battery is a battery that has lost available lithium due to an overhang defect.

Here, overhang is a term referring to the negative electrode area of the battery being wider than its positive electrode area. In other words, an overhang defect refers to a defect state in which the negative electrode area is smaller than the positive electrode area. An overhang defect may occur due to manufacturing problems or battery damage. In particular, it is known that batteries with an overhang defect have more lithium metal precipitated in the edge region than in the center region of the negative electrode.

For example, when analyzing a battery with an overhang defect using Raman spectroscopy, the $I_D/I_G$ ratio in the edge region is higher than that in the center region. Therefore, the overhang defect may be one of the causes of available lithium loss.

In the embodiment of FIG. 11, the first feature value ($pi_{BOL}$) of the first battery of the BOL state and the first feature value ($pi_{BOL}$) of the second battery of the BOL state are equal to 6.7%.

The first feature value ($pi_{MOL}$) of the first battery in the MOL (middle of life) state is 6.9%, and the first feature value ($pi_{MOL}$) of the second battery in the MOL state is 7.8%. That is, the first feature value ($pi_{MOL}$) of the second battery in which an overhang defect occurs is greater than the first feature value ($pi_{MOL}$) of the reference battery. Here, the first feature value ($pi_{MOL}$) of the first battery in the MOL state may be set as the first criterion value. Therefore, the control unit 130 may diagnose the state of the battery based on the result of comparing the first feature value of the battery and the preset first criterion value.

The available lithium loss rate ($L_{Li}$) of the first battery in the MOL state is 0.2%, and the available lithium loss rate ($L_{Li}$) of the second battery in the MOL state is 1.4%. That is, the available lithium loss rate ($L_{Li}$) of the second battery in which the overhang defect occurs is greater than the available lithium loss rate ($L_{Li}$) of the reference battery. Here, the available lithium loss rate ($L_{Li}$) of the first battery in the MOL state may be set to the second criterion value. Therefore, the control unit 130 may diagnose the state of the battery based on the result of comparing the available lithium loss rate of the battery and the preset second criterion value.

On the other hand, the positive electrode capacity loss rate ($L_Q$) of the first battery in the MOL state is 6.8%, and the positive electrode capacity loss rate ($L_Q$) of the second battery in the MOL state is 6.6%. In other words, the positive electrode capacity loss rates of the first and second batteries show a difference within a certain level, so the degree of loss of the positive electrode capacity of the second battery is normal.

In summary of FIG. 11, based on the first result of comparing the first criterion value (the first feature value ($pi_{MOL}$) of the first battery) and the first feature value ($pi_{MOL}$) of the second battery, the control unit 130 may diagnose the state of the battery as an available lithium loss state.

In addition, based on the second result of comparing the second criterion value (available lithium loss rate ($L_{Li}$) of the first battery) and the available lithium loss rate ($L_{Li}$) of the second battery, the control unit 130 may diagnose the state of the battery as an available lithium loss state.

Preferably, since the first result and the second result are the same, the control unit 130 may diagnose the state of the battery as an available lithium loss state.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the profile obtaining unit 110, the profile adjusting unit 120 and the control unit 130 of the apparatus 100 for diagnosing a battery may be implemented as components of the BMS.

Additionally, the apparatus 100 for diagnosing a battery according to the present disclosure may be provided in the battery pack. That is, the battery pack according to the present disclosure may include the above-described apparatus 100 for diagnosing a battery and at least one battery cell. Additionally, the battery pack may further include electrical components (relays, fuses, etc.) and a case.

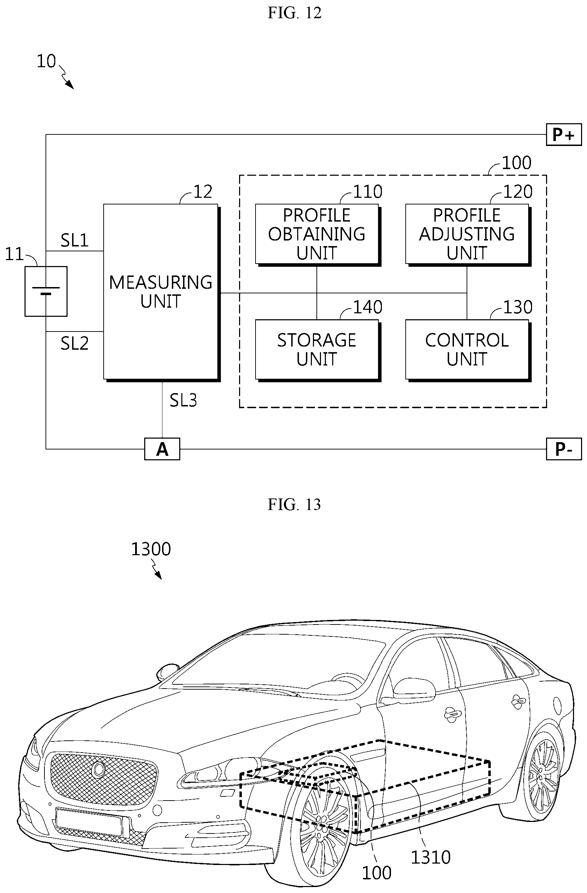

FIG. 12 is a drawing schematically showing a battery pack 10 including the apparatus 100 for diagnosing a battery according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the first sensing line SL1, the second sensing line SL2, and the third sensing line SL3. Specifically, the measuring unit 12 may be connected to the positive electrode terminal of the battery 11 through the first sensing line SL1 and connected to the negative electrode terminal of the battery 11 through the second sensing line SL2. The measuring unit 12 may measure the voltage of the battery 11 based on the voltage measured at each of the first sensing line SL1 and the second sensing line SL2.

Also, the measuring unit 12 may be connected to the current measuring unit A through the third sensing line SL3. For example, the current measuring unit A may be an ammeter or a shunt resistor capable of measuring the charging current and the discharging current of the battery 11. The measuring unit 12 may measure the charging current of the battery 11 through the third sensing line SL3 to calculate the charge amount. In addition, the measuring unit 12 may measure the discharging current of the battery 11 through the third sensing line SL3 to calculate the discharge amount.

An external device may be connected to the positive electrode terminal P+ and the negative electrode terminal P- of the battery pack 10. For example, the external device may be a charging device or a load. In addition, the positive electrode terminal of the battery 11, the positive electrode terminal P+ of the battery pack 10, the external device, the negative electrode terminal P- of the battery pack 10, and the negative electrode terminal of the battery 11 may be electrically connected.

FIG. 13 is a drawing schematically showing a vehicle 1300 according to another embodiment of the present disclosure.

Referring to FIG. 13, the battery pack 1310 according to the embodiment of the present disclosure may be included in a vehicle 1300, such as an electric vehicle (EV) or a hybrid vehicle (HV). In addition, the battery pack 1310 may drive the vehicle 1300 by supplying power to a motor through an inverter provided in the vehicle 1300. Here, the battery pack 1310 may include the apparatus 100 for diagnosing a battery. That is, the vehicle 1300 may include the apparatus 100 for diagnosing a battery. In this case, the apparatus 100 for diagnosing a battery may be an onboard device included in the vehicle 1300.

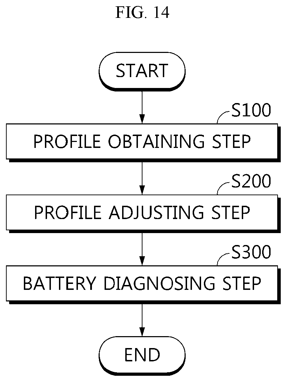

FIG. 14 is a diagram schematically showing a method for diagnosing a battery according to still another embodiment of the present disclosure.

Referring to FIG. 14, the method for diagnosing a battery may include a profile obtaining step (S100), a profile adjusting step (S200), and a diagnosing step (S300).

Preferably, each step of the method for diagnosing a battery may be performed by the apparatus 100 for diagnosing a battery. Hereinafter, for convenience of explanation, content that overlaps with the content described above will be omitted or briefly described.

The profile obtaining step (S100) is a step of obtaining a battery profile representing a corresponding relationship between voltage and capacity of a battery, and may be performed by the profile obtaining unit 110.

For example, the profile obtaining unit 110 may directly receive the battery profile from the outside. That is, the profile obtaining unit 110 may obtain the battery profile by being connected to the outside via wire and/or wirelessly and receiving the battery profile.

As another example, the profile obtaining unit 110 may receive battery information about the voltage and capacity of the battery. Then, the profile obtaining unit 110 may generate a battery profile based on the received battery information. That is, the profile obtaining unit 110 may obtain the battery profile by directly generating the battery profile based on the battery information.

The profile adjusting step (S200) is a step of adjusting a preset first reference profile and a second reference profile to correspond to the battery profile and generating a first profile according to the adjustment result, and may be performed by the profile adjusting unit 120.

For example, the profile adjusting unit 120 may generate a plurality of comparison profiles by shifting or capacity-scaling the first reference profile and the second reference profile, and specify a comparison profile among the plurality of comparison profiles that has a minimum error with respect to the battery profile. Then, the profile adjusting unit 120 may determine an adjusted first reference profile and an adjusted second reference profile corresponding to the specified comparison profile as a first profile and a second profile, respectively.

The diagnosing step (S300) is a step of diagnosing the state of the battery based on the first feature value of the first feature point included in the first profile, and may be performed by the control unit 130.

In one embodiment, the control unit 130 may diagnose the state of the battery based on the result of comparing the first feature value and the first criterion value.

In another embodiment, the control unit 130 may calculate the available lithium loss rate of the battery based on the first feature value, and diagnose the state of the battery based on the calculated available lithium loss rate.

In still another embodiment, the control unit 130 may diagnose the state of the battery by considering both the result of comparing the first feature value with the first criterion value and the result of comparing the available lithium loss rate of the battery with the second criterion value.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

(Explanation of reference signs)

10: battery pack
11: battery
12: measuring unit
100: apparatus for diagnosing a battery
110: profile obtaining unit
120: profile adjusting unit
130: control unit
140: storage unit
1300: vehicle
1310: battery pack

**Claims**

1. An apparatus for diagnosing a battery, comprising:

   a profile obtaining unit configured to obtain a battery profile representing a corresponding relationship between voltage and capacity of a battery;
   a profile adjusting unit configured to adjust a preset first reference profile and a preset second reference profile to correspond to the battery profile and generate a first profile according to the adjustment result; and
   a control unit configured to diagnose a state of the battery based on a first feature value for a first feature point included in the first profile.

2. The apparatus for diagnosing a battery according to claim 1,
   wherein the control unit is configured to diagnose the state of the battery as a normal state or an available lithium loss state.

3. The apparatus for diagnosing a battery according to claim 2,
   wherein the control unit is configured to:

   diagnose the state of the battery as the available lithium loss state when the first feature value exceeds a preset first criterion value, and diagnose the state of the battery as the normal state when the first feature value is less than or equal to the first criterion value.

4. The apparatus for diagnosing a battery according to claim 2,
   wherein the control unit is configured to calculate an available lithium loss rate based on a preset first reference value, a preset second reference value and the first feature value, compare the calculated available lithium loss rate with a preset second criterion value, and diagnose the state of the battery based on the comparison result.

5. The apparatus for diagnosing a battery according to claim 4,
   wherein the control unit is configured to:

   diagnose the state of the battery as the available lithium loss state when the available lithium loss rate exceeds the second criterion value, and diagnose the state of the battery as the normal state when the available lithium loss rate is less than or equal to the second criterion value.

6. The apparatus for diagnosing a battery according to claim 4,

   wherein the first reference value is preset to a SOC of a first reference point included in the first reference profile, and
   wherein the second reference value is preset to a SOC of a second reference point included in the first reference profile.

7. The apparatus for diagnosing a battery according to claim 1,
   wherein the first feature value is a SOC of the first feature point included in the first profile.

8. A battery pack, comprising the apparatus for diagnosing a battery according to any one of claims 1 to 7.

9. A vehicle, comprising the apparatus for diagnosing a battery according to any one of claims 1 to 7.

10. A method for diagnosing a battery, comprising:

    a profile obtaining step of obtaining a battery profile representing a corresponding relationship between voltage and capacity of a battery;
    a profile adjusting step of adjusting a preset first reference profile and a preset second reference profile to correspond to the battery profile and generating a first profile according to the adjustment result; and
    a battery diagnosing step of diagnosing a state of the battery based on a first feature value for a first feature point included in the first profile.

FIG. 1

```
                                                    100
┌─────────────────────────────────────────────┐
│         APPARATUS FOR DIAGNOSING BATTERY      │
│  ┌───────────────────────────────────────┐   │
│  │        PROFILE OBTAINING UNIT          │───┼── 110
│  └───────────────────────────────────────┘   │
│  ┌───────────────────────────────────────┐   │
│  │        PROFILE ADJUSTING UNIT          │───┼── 120
│  └───────────────────────────────────────┘   │
│  ┌───────────────────────────────────────┐   │
│  │             CONTROL UNIT               │───┼── 130
│  └───────────────────────────────────────┘   │
│  ┌───────────────────────────────────────┐   │
│  │             STORAGE UNIT               │───┼── 140
│  └───────────────────────────────────────┘   │
└─────────────────────────────────────────────┘
```

FIG. 2

FIG. 3

FIG. 4

FIG. 5

FIG. 6

FIG. 7

FIG. 8

FIG. 9

FIG. 10

FIG. 11

| BATTERY FACTOR | FIRST BATTERY | SECOND BATTERY |
|---|---|---|
| $pi_{BOL}$ (%) | 6.7 | 6.7 |
| $pi_{MOL}$ (%) | 6.9 | 7.8 |
| $L_{Li}$ (%) | 0.2 | 1.4 |
| $L_Q$ (%) | 6.8 | 6.6 |

FIG. 12

10

P+

100

12

110

PROFILE
OBTAINING
UNIT

120

PROFILE
ADJUSTING
UNIT

SL1

11

MEASURING
UNIT

140

STORAGE
UNIT

130

CONTROL
UNIT

SL2

SL3

A

P-

FIG. 13

1300

1310

100

FIG. 14

```
              ┌─────────┐
              │  START  │
              └─────────┘
                   │
                   ▼              ⌐S100
  ┌──────────────────────────────────┐
  │      PROFILE OBTAINING STEP       │
  └──────────────────────────────────┘
                   │
                   ▼              ⌐S200
  ┌──────────────────────────────────┐
  │      PROFILE ADJUSTING STEP       │
  └──────────────────────────────────┘
                   │
                   ▼              ⌐S300
  ┌──────────────────────────────────┐
  │     BATTERY DIAGNOSING STEP       │
  └──────────────────────────────────┘
                   │
                   ▼
              ┌─────────┐
              │   END   │
              └─────────┘
```

## INTERNATIONAL SEARCH REPORT

| International application No. |
|---|
| **PCT/KR2025/000327** |

### A. CLASSIFICATION OF SUBJECT MATTER

**G01R 31/392**(2019.01)i; **G01R 31/382**(2019.01)i; **G01R 31/396**(2019.01)i; **H01M 10/052**(2010.01)i

According to International Patent Classification (IPC) or to both national classification and IPC

### B. FIELDS SEARCHED

Minimum documentation searched (classification system followed by classification symbols)

G01R 31/392(2019.01); G01R 31/36(2006.01); G01R 31/367(2019.01); G01R 31/374(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 진단(diagnosis), 프로파일(profile), 리튬(Li, Lithium), 정상 상태 (steady state)

### C. DOCUMENTS CONSIDERED TO BE RELEVANT

| Category* | Citation of document, with indication, where appropriate, of the relevant passages | Relevant to claim No. |
|---|---|---|
| Y | KR 10-2024-0006307 A (LG ENERGY SOLUTION, LTD.) 15 January 2024 (2024-01-15) <br> See claims 1-2. | 1-10 |
| Y | KR 10-2021-0154027 A (LG ENERGY SOLUTION, LTD.) 20 December 2021 (2021-12-20) <br> See paragraphs [0054]-[0088] and claim 1. | 1-10 |
| Y | KR 10-2021-0146699 A (LG ENERGY SOLUTION, LTD.) 06 December 2021 (2021-12-06) <br> See paragraphs [0051]-[0079]. | 4-6 |
| A | KR 10-2023-0019705 A (LG ENERGY SOLUTION, LTD.) 09 February 2023 (2023-02-09) <br> See claims 1-10. | 1-10 |
| A | KR 10-2021-0031226 A (LG CHEM, LTD.) 19 March 2021 (2021-03-19) <br> See claims 1-15. | 1-10 |

☐ Further documents are listed in the continuation of Box C.    ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **08 April 2025** | **08 April 2025** |

| Name and mailing address of the ISA/KR | Authorized officer |
|---|---|
| **Korean Intellectual Property Office** <br> **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2025/000327**

| Patent document cited in search report | | | Publication date (day/month/year) | Patent family member(s) | | | Publication date (day/month/year) |
|---|---|---|---|---|---|---|---|
| KR | 10-2024-0006307 | A | 15 January 2024 | None | | | |
| KR | 10-2021-0154027 | A | 20 December 2021 | None | | | |
| KR | 10-2021-0146699 | A | 06 December 2021 | CN | 114174845 | A | 11 March 2022 |
| | | | | CN | 114174845 | B | 09 April 2024 |
| | | | | EP | 4053573 | A1 | 07 September 2022 |
| | | | | JP | 2022-545940 | A | 01 November 2022 |
| | | | | JP | 7338101 | B2 | 05 September 2023 |
| | | | | US | 2023-0023014 | A1 | 26 January 2023 |
| | | | | WO | 2021-241886 | A1 | 02 December 2021 |
| KR | 10-2023-0019705 | A | 09 February 2023 | CN | 116457678 | A | 18 July 2023 |
| | | | | EP | 4224182 | A1 | 09 August 2023 |
| | | | | JP | 2023-547133 | A | 09 November 2023 |
| | | | | JP | 7585587 | B2 | 19 November 2024 |
| | | | | US | 2024-0044995 | A1 | 08 February 2024 |
| | | | | WO | 2023-013967 | A1 | 09 February 2023 |
| KR | 10-2021-0031226 | A | 19 March 2021 | CN | 114270202 | A | 01 April 2022 |
| | | | | CN | 114270202 | B | 09 April 2024 |
| | | | | EP | 4012427 | A1 | 15 June 2022 |
| | | | | EP | 4012427 | B1 | 17 July 2024 |
| | | | | ES | 2994208 | T3 | 20 January 2025 |
| | | | | HU | E068013 | T2 | 28 December 2024 |
| | | | | JP | 2022-539744 | A | 13 September 2022 |
| | | | | JP | 7279294 | B2 | 23 May 2023 |
| | | | | PL | 4012427 | T3 | 23 September 2024 |
| | | | | US | 11874330 | B2 | 16 January 2024 |
| | | | | US | 2022-0276314 | A1 | 01 September 2022 |
| | | | | WO | 2021-049882 | A1 | 18 March 2021 |

Form PCT/ISA/210 (patent family annex) (July 2022)

**REFERENCES CITED IN THE DESCRIPTION**

**Patent documents cited in the description**

- KR 1020240006174